# EUROPEAN PATENT SPECIFICATION

(11) **EP 2 783 023 B1**
(45) Date of publication and mention of the grant of the patent: **04.11.2020**
(21) Application number: 11876170.9
(22) Date of filing: 22.11.2011
(51) Int. Cl.: C23C 16/455, H01L 31/18

(54) **METHOD OF ATOMIC LAYER DEPOSITION FOR PROCESSING A BATCH OF SUBSTRATES**
VERFAHREN FÜR VERARBEITUNG EINER CHARGE VON SUBSTRATEN MITTELS ATOMLAGENABSCHEIDUNG
PROCÉDÉ DE DÉPÔT DE COUCHE ATOMIQUE POUR LE TRAITEMENT D'UN LOT DE SUBSTRATS

(43) Date of publication of application: 01.10.2014
(73) Proprietor: Picosun Oy, 02150 Espoo (FI)
(72) Inventor: LINDFORS, Sven, FI-02230 Espoo (FI); SOININEN, Pekka J., FI-02200 Espoo (FI)
(74) Representative: Espatent Oy
(86) International application number: PCT/FI2011/051017
(87) International publication number: WO 2013/076347

(56) References cited:
- WO-A1-2009/144371
- WO-A2-2008/002780
- US-A1- 2003 109 094
- US-A1- 2004 067 641
- US-A1- 2008 318 442
- US-A1- 2010 083 900
- US-A1- 2010 083 900
- US-A1- 2010 098 851
- US-A1- 2010 190 343
- 'SoLayTec ultrafast ALD fo AIOx' SOLAYTEC 08 December 2011, XP054975615 Retrieved from the Internet: <URL:http://www.youtube.com/watch?v=juXHYLf aGVU> [retrieved on 2012-05-21]

## Description

An atomic layer deposition reactor for processing a batch of substrates and method thereof.

### FIELD OF THE INVENTION

The present invention generally relates to methods of deposition. More particularly, but not exclusively, the invention relates to such deposition methods in which material is deposited on surfaces by sequential self-saturating surface reactions.

### BACKGROUND OF THE INVENTION

Atomic Layer Epitaxy (ALE) method was invented by Dr. Tuomo Suntola in the early 1970's. Another generic name for the method is Atomic Layer Deposition (ALD) and it is nowadays used instead of ALE. ALD is a special chemical deposition method based on the sequential introduction of at least two reactive precursor species to a substrate. The substrate is located within a reaction space. The reaction space is typically heated. The basic growth mechanism of ALD relies on the bond strength differences between chemical adsorption (chemisorption) and physical adsorption (physisorption). ALD utilizes chemisorption and eliminates physisorption during the deposition process. During chemisorption a strong chemical bond is formed between atom(s) of a solid phase surface and a molecule that is arriving from the gas phase. Bonding by physisorption is much weaker because only van der Waals forces are involved. Physisorption bonds are easily broken by thermal energy when the local temperature is above the condensation temperature of the molecules.

The reaction space of an ALD reactor comprises all the heated surfaces that can be exposed alternately and sequentially to each of the ALD precursor used for the deposition of thin films. A basic ALD deposition cycle consists of four sequential steps: pulse A, purge A, pulse B and purge B. Pulse A typically consists of metal precursor vapor and pulse B of non-metal precursor vapor, especially nitrogen or oxygen precursor vapor. Inactive gas, such as nitrogen or argon, and a vacuum pump are used for purging gaseous reaction by-products and the residual reactant molecules from the reaction space during purge A and purge B. A deposition sequence comprises at least one deposition cycle. Deposition cycles are repeated until the deposition sequence has produced a thin film of desired thickness.

Precursor species form through chemisorption a chemical bond to reactive sites of the heated surfaces. Conditions are typically arranged in such a way that no more than a molecular monolayer of a solid material forms on the surfaces during one precursor pulse. The growth process is thus self-terminating or saturative. For example, the first precursor can include ligands that remain attached to the adsorbed species and saturate the surface, which prevents further chemisorption. Reaction space temperature is maintained above condensation temperatures and below thermal decomposition temperatures of the utilized precursors such that the precursor molecule species chemisorb on the substrate(s) essentially intact. Essentially intact means that volatile ligands may come off the precursor molecule when the precursor molecules species chemisorb on the surface. The surface becomes essentially saturated with the first type of reactive sites, i.e. adsorbed species of the first precursor molecules. This chemisorption step is typically followed by a first purge step (purge A) wherein the excess first precursor and possible reaction by-products are removed from the reaction space. Second precursor vapor is then introduced into the reaction space. Second precursor molecules typically react with the adsorbed species of the first precursor molecules, thereby forming the desired thin film material. This growth terminates once the entire amount of the adsorbed first precursor has been consumed and the surface has essentially been saturated with the second type of reactive sites. The excess of second precursor vapor and possible reaction by-product vapors are then removed by a second purge step (purge B). The cycle is then repeated until the film has grown to a desired thickness. Deposition cycles can also be more complex. For example, the cycles can include three or more reactant vapor pulses separated by purging steps. All these deposition cycles form a timed deposition sequence that is controlled by a logic unit or a microprocessor.

Thin films grown by ALD are dense, pinhole free and have uniform thickness. For example, in an experiment aluminum oxide has been grown by thermal ALD from trimethylaluminum (CH₃)3Al, also referred to as TMA, and water at 250 - 300 °C resulting in only about 1% non-uniformity over a substrate wafer.

General information on ALD thin film processes and precursors suitable for ALD thin film processes can be found in Dr. Riikka Puurunen's review article, "Surface chemistry of atomic layer deposition: a case study for the trimethylaluminum/water process", Journal of Applied Physics, vol. 97, 121301 (2005).

Recently, there has been increased interest in batch ALD reactors capable of increased deposition throughput. US 2010/083900 A1 discloses an ALD apparatus and method for pre-heating and processing a batch of substrates.

### SUMMARY

According to a first example aspect of the invention there is provided a method according to claim 1.

In certain embodiments, the substrates comprise silicon wafers, glass plates, metal plates or polymer plates.

In certain embodiments, the batch of substrates (generally at least one batch of substrates) is loaded from a different side of the reaction chamber module than the at least one batch of substrates is unloaded from the reaction chamber module. The loading and unloading may be performed on opposite sides of the reaction chamber module or reactor. The loading and unloading may be performed horizontally.

In certain embodiments, the method comprises:
post-processing the processed batch of substrates in a post-processing module of the reactor, where the pre-processing module, the reaction chamber module, and the post-processing module are located in a row.

In certain embodiment, the modules have been integrated into a single device. In certain embodiments, there is a continuous route through the modules. In certain embodiments, the profile of each of the modules is the same.

In the method according to the invention, said processing by an atomic layer deposition process comprises depositing material on the batch of substrates by sequential self-saturating surface reactions.

In the method according to the invention, said pre-processing module is a pre-heating module and pre-processing comprises pre-heating the batch of substrates.

In certain embodiments, said post-processing module is a cooling module and said post-processing comprises cooling the batch of substrates.

In certain embodiments, the method comprises transporting the batch of substrates in one direction through the whole processing line, the processing line comprising the pre-processing, reaction chamber and post-processing modules.

In certain embodiment, the modules lie in a horizontal row. The transport mechanism through the modules is one-way through each of the modules.

In certain embodiment, pre-processed substrates are loaded into the reaction chamber module from one side of the module and the ALD processed substrates are unloaded from the module from the opposite side of the module. In an embodiment, the shape of the reaction chamber module is an elongated shape.

In certain embodiments, the pre-processing module is a first load lock, and the method comprises pre-heating the batch of substrates in a raised pressure in the first load lock by means of heat transport.

The raised pressure may refer to a pressure higher than vacuum pressure, such as room pressure. Heat transport comprises thermal conduction, convection and electromagnetic radiation. At low pressures heat is transported through the gas space mostly by electromagnetic radiation which is typically infrared radiation. At raised pressure heat transport is enhanced by the thermal conduction through the gas and by convection of the gas. Convection can be natural convection due to temperature differences or it can be forced convection carried out by a gas pump or a fan. The batch of substrates may be heated by heat transport with the aid of inactive gas, such as nitrogen or similar. In certain embodiment, inactive gas is guided into the pre-processing module and said inactive gas is heated by at least one heater.

In certain embodiments, the post-processing module is a second load lock, and the method comprises cooling the batch of substrates in a raised pressure higher than vacuum pressure in the second load lock by means of heat transport.

In certain embodiments, the method comprises dividing the batch of substrates into substrate subsets, and processing each of the subsets simultaneously in the reaction chamber module, each subset having its own gas flow inlet and gas flow outlet.

In certain embodiments, each subset are processed in a confined space formed be interior dividing walls.

In certain embodiments, the method comprises depositing aluminum oxide on solar cell structure.

In certain embodiments, the method comprises depositing Zn₁₋ₓMgₓO or ZnO₁₋ₓSₓ buffer layer on solar cell structure.

According to an example aspect of the disclosure there is provided an apparatus for performing the method according to the invention comprising:
a reaction chamber module of an atomic layer deposition reactor configured to process a batch of substrates carried by a carriage by an atomic layer deposition process; and
a loading and unloading arrangement allowing loading carried by a carriage the batch of substrates before processing into the reaction chamber module via a different route than the batch of substrates is unloaded after processing,
wherein the reaction chamber module is configured to divide the batch of substrates into substrate subsets, and configured to process each of the subsets simultaneously in the reaction chamber module, each subset having its own gas flow inlet and gas flow outlet.

The apparatus may be an atomic layer deposition reactor, an ALD reactor. In exemplary embodiments, suitable for performing the method according to the invention, the apparatus comprises:
a pre-processing module of the atomic layer deposition reactor configured to pre-process the batch of substrates;
the reaction chamber module of the reactor configured to process the pre-processed batch of substrates by the atomic layer deposition process; and a post-processing module of the reactor configured to post-process the processed batch of substrates, where the pre-processing module, the reaction chamber module, and the post-processing module are located in a row.

In certain embodiments, said processing by an atomic layer deposition process comprises depositing material on the batch of substrates by sequential self-saturating surface reactions.

In certain embodiments, said pre-processing module is a pre-heating module configured to pre-heat the batch of substrates to a temperature above room temperature.

In certain embodiments, the apparatus is configured for transporting the batch of substrates in one direction through the whole processing line, the processing line comprising the pre-processing, reaction chamber and post-processing modules. In certain embodiments, the pre-processing module is a first load lock configured to pre-heat the batch of substrates in a raised pressure by means of heat transport.

In certain embodiments, the post-processing module is a second load lock configured to cool the batch of substrates in a raised pressure by means of heat transport.

In certain embodiments, the reaction chamber module comprises partition walls or is configured to receive partition walls dividing the batch of substrates into substrate subsets, each subset having its own gas flow inlet and gas flow outlet.

According to another example there is provided an apparatus comprising:
a reaction chamber module of an atomic layer deposition reactor configured to process a batch of substrates by an atomic layer deposition process; and means for loading the batch of substrates before processing into the reaction chamber module via a different route than the batch of substrates is unloaded after processing.

Different non-binding example aspects and embodiments of the present invention have been illustrated in the foregoing. The above embodiments are used merely to explain selected aspects or steps that may be utilized in implementations of the present invention. Some embodiments may be presented only with reference to certain example aspects of the invention. Any appropriate combinations of the embodiments may be formed.

### BRIEF DESCRIPTION OF THE DRAWINGS

The method of the invention, and apparatus suitable for performing said method will now be described, by way of example only, with reference to the accompanying drawings, in which:
- Figs. 1A - 1J: show a method of batch processing in a deposition reactor in accordance with an example embodiment;
- Fig. 2: shows a deposition reactor in accordance with an example embodiment;
- Fig. 3: shows a carriage in another example embodiment;
- Fig. 4: shows placement of substrates in a batch in accordance with an example embodiment;
- Figs. 5A - 5B: show gas flow directions in accordance example embodiments;
- Fig. 6: shows a curved rectangular tube furnace in accordance with an example embodiment;
- Fig. 7: shows a curved rectangular tube furnace in accordance with another example embodiment;
- Fig. 8: shows a curved rectangular tube furnace in accordance with yet another example embodiment;
- Fig. 9: shows a rectangular tube furnace in accordance with an example embodiment;
- Fig. 10: shows a rectangular tube furnace in accordance with another example embodiment;
- Fig. 11: shows a rectangular tube furnace in accordance with yet another example embodiment;
- Fig. 12: shows a round tube furnace in accordance with an example embodiment;
- Fig. 13: shows a round tube furnace in accordance with another example embodiment; and
- Figs. 14A - 14D: show a method of a single batch processing in a deposition reactor in accordance with an example embodiment.

### DETAILED DESCRIPTION

In the following description, Atomic Layer Deposition (ALD) technology is used as an example. Unless specifically restricted by the appended patent claims, the embodiments of the present invention are not strictly limited to that technology and to an equivalent technology, but certain embodiments may be applicable also in methods and apparatus utilizing another comparable atomic-scale deposition technology or technologies.

The basics of an ALD growth mechanism are known to a skilled person. Details of ALD methods have also been described in the introductory portion of this patent application. These details are not repeated here but a reference is made to the introductory portion with that respect.

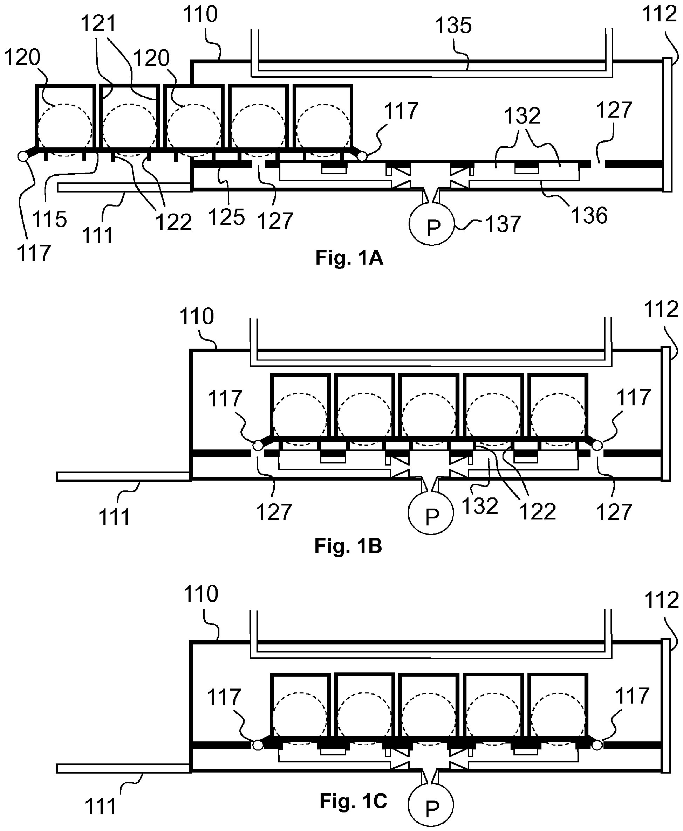

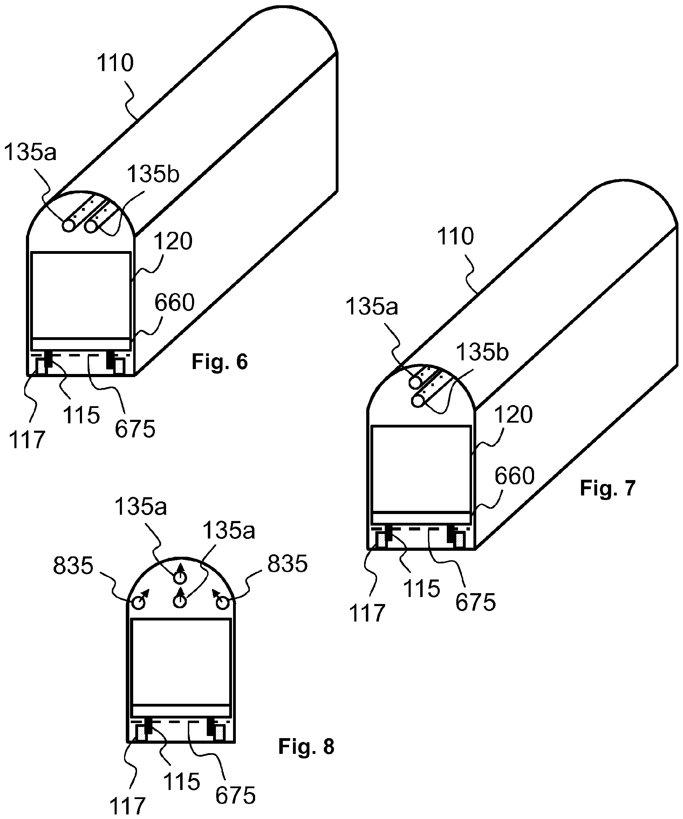

Figs. 1A - 1J show a method of batch processing in a deposition reactor in accordance with an example embodiment. The deposition reactor comprises a horizontal reaction chamber module 110, a tube furnace, which may have a rectangular cross-section, a curved rectangular cross-section, or a round cross-section as shown in more detail with reference to Figs. 6 - 13. In other embodiments, the cross-section may be yet another cross-section shape suitable for the purpose.

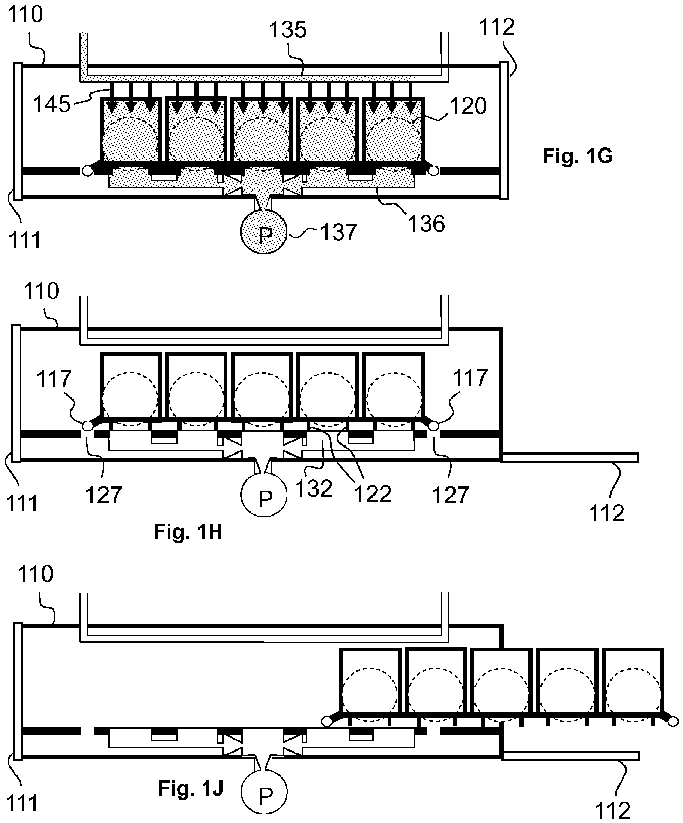

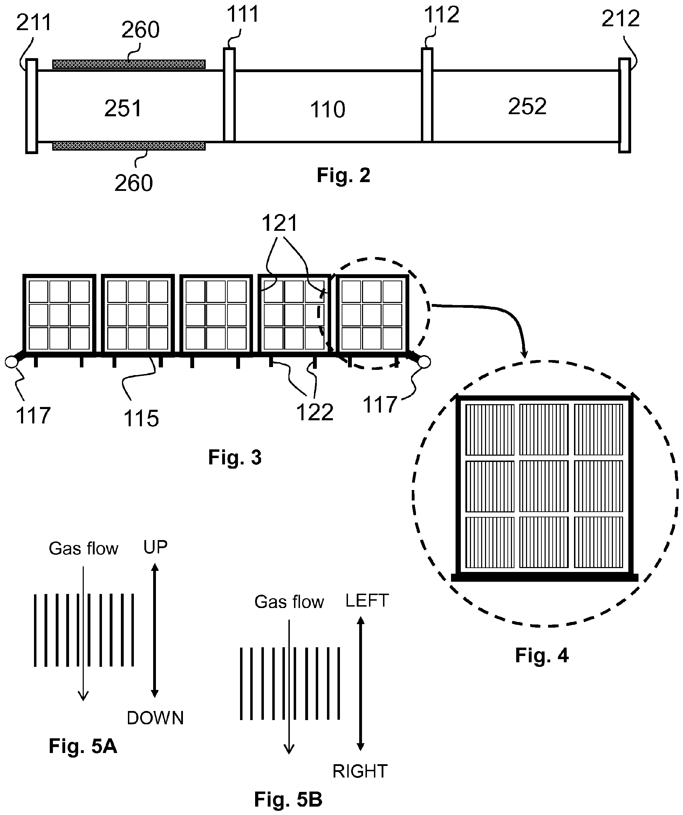

The reaction chamber module 110 comprises gates 111 and 112 at respective ends of the module 110 for loading and unloading a carriage 115 carrying substrate holders each carrying a batch of substrates 120. The gates 111 and 112 may open as shown in Figs. 1A and 1H. In alternative embodiments, the gates may be gate valves or similar requiring very little space when opening and closing. In those embodiments, for example, a fixed or mobile pre-processing module can be attached to the module 110 on the side of gate 111. Similarly, in alternative embodiment, a fixed or mobile post-processing module can be attached to the module 110 on the side of gate 112. This is in more detail described later in this description in connection with Fig. 2.

Each batch of substrates may reside in its own semiconfined space formed by flow guides or guide plates 121 which surround each of the batches on the sides. Each semiconfined space therefore forms a kind of a box that has at least partially open top and bottom side allowing exposure of substrates in the box to process gases and removal of process gases from the box. The flow guides 121 may form a permanent structure of the carriage 115. A substrate holder carrying a batch of substrates can be transferred into such a box by a loading robot or similar before processing. Alternatively, the flow guides 121 may be integrated to a substrate holder. In those embodiments, and in other embodiments, a robot or similar may move a batch of substrates from a regular plastic wafer carrier cassette or substrate holder into a substrate holder (made of aluminum, stainless steel or silicon carbide, for example) which can tolerate the processing temperatures and precursors of ALD. These substrate holders, which may have the flow guides 121 forming the box walls, are then loaded into the carriage 115.

The substrates 120 may be round substrate wafers as shown in Fig. 1A or rectangular wafers, square in particular, as shown in more detail later in this description in connection with Figs. 3-14D. Each batch may consist of wafers placed adjacent to each other to form a horizontal stack with open gaps between wafers as shown in more detail later in this description in connection with for example Figs. 4-5B.

The reaction chamber module 110 shown in Figs. 1A-1J comprises precursor vapor in-feed lines 135 in an upper portion of the module. There may be one in-feed line for each precursor vapor. In the embodiment shown in Figs. 1A-1J there are two in-feed lines which are horizontally adjacent. In other embodiments, the in-feed lines may be vertically adjacent. Some examples on the placement of the in-feed lines have been shown in Figs. 6-13. Precursor vapor is fed to the in-feed line at least from one point. In other embodiments, in large reactors the in-feed line may be so long that it is advantageous to have more than one feed point of the precursor vapor to the in-feed line, for example at both ends of the in-feed line.

There may be inlet openings in the in-feed lines allowing gases and vapors leave the in-feed lines and enter the reaction chamber. In an embodiment, the in-feed lines therefore are perforated pipelines. The position of the inlet openings depends on the embodiment. They may be, for example, in an upper and/or lower and/or side surface of the in-feed lines. The feedthrough of the in-feed lines into the reaction chamber may be implemented in various ways depending on the implementation. One possibility is to implement at least one feedthrough for each in-feed line through the ceiling of the reaction chamber. Another possibility is to implement at least one feedthrough for each in-feed line through a side wall of the reaction chamber.

The reaction chamber module 110 comprises an exhaust channel 136 below the support surface practically along the whole length of the module 110. During processing, reaction by-products and surplus reactant molecules are purged and / or pumped to a vacuum pump 137 via the exhaust channel 136.

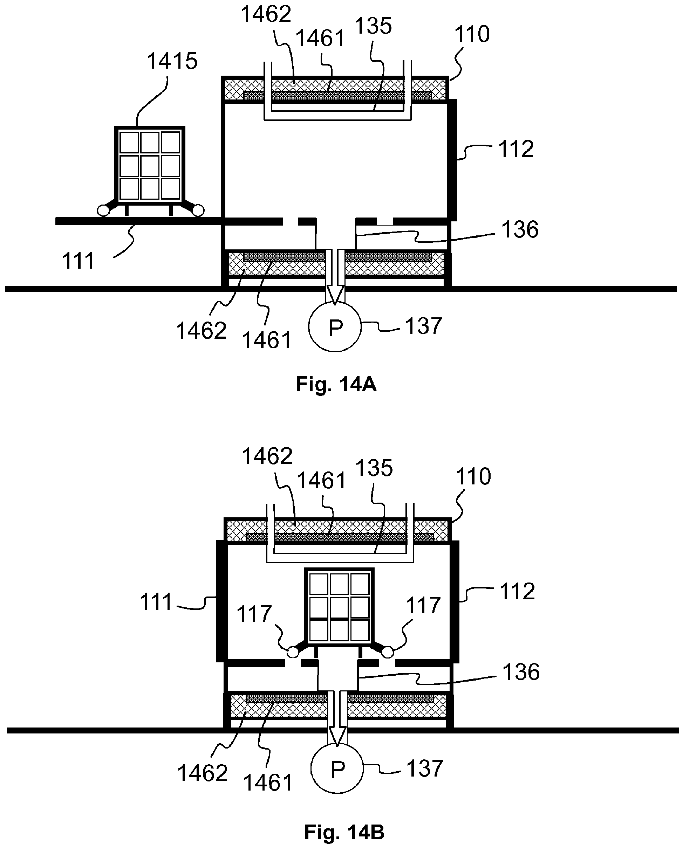

In an embodiment, the reaction chamber module 110 comprises at least one heater heating the inside of the reaction chamber, that is, practically the reaction space. One possible heating arrangement is shown later in this description in connection with Figs. 14A-14D. The at least one heater may be covered by a thermal insulator layer in directions other than the one pointing towards the reaction space.

The carriage 115 comprises wheels 117 or other moving means so that the carriage 115 can move or slide into and inside the module 110 along a track or rails 125 or along other support surface. The support surface comprises recesses 127 or other reception means for locking the carriage 115 into a right position for processing. In the embodiment shown in Figs. 1B and 1C the wheels 117 are lowered into the recesses 127. The carriage 115 may have lower guiding means or plates 122 in the area of each of the boxes that fit into the space 132 formed in the connection or below the support surface.

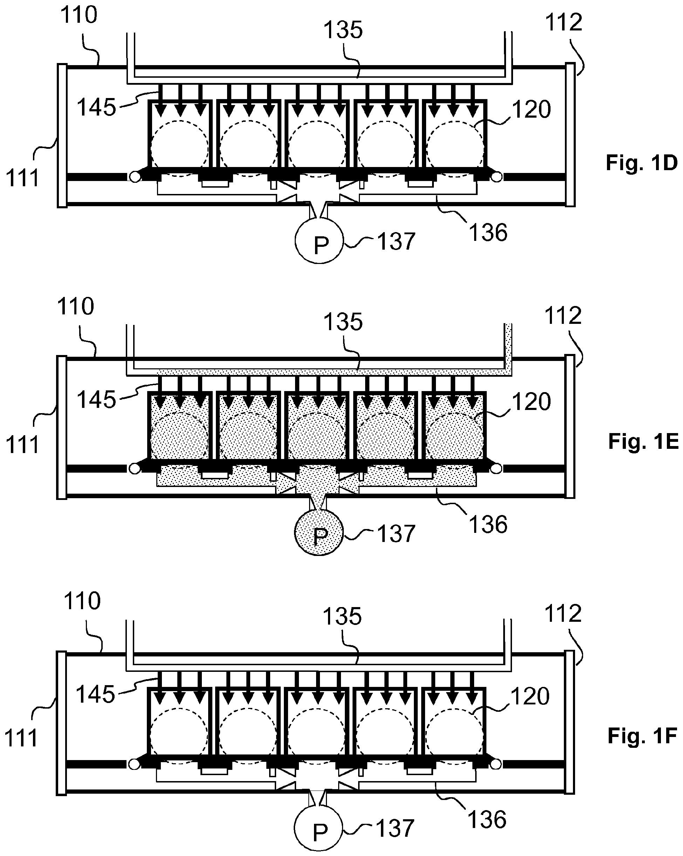

In Fig. 1D, the carriage 115 is in the processing position inside the module 110. The in-feed lines 135 are in fluid communication with the exhaust channel 136 and vacuum pump 137 through each of the boxes housing the substrate batches.

Initially, the reaction chamber is at room pressure. The loading hatch or gate 111 which was opened during loading has been closed after the reaction chamber has been loaded with the batches of substrates 120. The reaction chamber is then pumped into vacuum by the vacuum pump 137. The loaded batches may have been pre-processed, for example, pre-heated into the processing temperature range (meaning the actual processing temperature or at least close to the processing temperature) in a fixed or mobile pre-processing module. Alternatively, they may be heated in the reaction chamber.

Inactive purge (carrier) gas, such as nitrogen or similar, flows from the in-feed lines 135 into each of the boxes, as depicted by arrows 145. The balance between the flow rate of inactive purge (carrier) gas to the reaction chamber and the pumping speed of gas out of the reaction chamber keeps the reaction chamber pressure typically in the rage of about 0.1 - 10 hPa, preferably about 0.5 - 2 hPa during the deposition process.

A deposition process consists of one or more consecutive deposition cycles. Each deposition cycle (ALD cycle) may consist of a first precursor pulse (or pulse period) followed by a first purge step (or period), which is followed by a second precursor pulse (or pulse period) followed by a second purge step (or period).

Fig. 1E shows the first precursor pulse period during which the substrates are exposed to a first precursor vapor. The route of gas flow is from the in-feed line 135 into the boxes housing the substrate batches and via the exhaust channel 136 into the pump 137.

Fig. 1F shows the subsequent first purge period during which inactive gas flows through the reaction chamber and pushes gaseous reaction byproducts and surplus precursor vapor to the exhaust channel 136 and further to the pump 137.

Fig. 1G shows the second precursor pulse period during which the substrates are exposed to a second precursor vapor. The route of gas flow is, again, from the in-feed line 135 into the boxes housing the substrate batches and via the exhaust channel 136 into the pump 137.

After a second purge period, the deposition cycle is repeated as many times as needed to grow a material layer of desired thickness onto the substrates 120.

In an example ALD deposition process, aluminum oxide Al₂O₃ is grown on batches of substrates 120 using trimethyl aluminum TMA as the first precursor and water H₂O as the second precursor. In an example embodiment, the substrates 120 comprise solar cell structures onto which aluminum oxide is grown. In an example embodiment, the processing temperature is about 200 °C.

After processing, the reaction chamber module 110 is reverted back into room pressure. The carriage 115 is raised from the recesses 127 as shown in Fig. 1H. And the carriage 115 is moved out of the reaction chamber module 110 via the opened gate 112 as shown in Fig. 1J.

The embodiment shown in Figs. 1A-1J thus illustrated a method of ALD batch processing in which the batch(es) of substrates were loaded before processing into the reaction chamber module via a different route than the batch(es) of substrates were unloaded from the reaction chamber module after processing.

In an alternative embodiment, the support surface (reference numeral 125, Fig. 1A) may be omitted. Instead, there may be a mesh, a perforated plate or a similar construction element in the carriage below the boxes extending along the area of each of the boxes so that the exhaust channel is formed below the carriage. In this embodiment, the carriage can be moved, for example, directly on the floor of the reaction chamber module. This embodiment is shown in more detail later in the description in connection with Figs. 6-8.

In another alternative embodiment, the mesh can be attached to the support surface part. In this embodiment, the carriage can be moved on the support surface but the carriage would not typically have the lower guiding means or plates.

The embodiments in which a mesh is present can be implemented without forming the boxes at all. Instead the mesh can be designed such that the gas flow in the reaction space is as uniform as possible so that a uniform growth on each surface of the substrates can be achieved. For example, the size of the openings in the mesh can be different depending on the distance from a feedthrough conduit to the vacuum pump.

Fig. 2 shows a deposition reactor in accordance with another embodiment. However, what has been presented in the preceding in the connection of Figs. 1A-1F is by default applicable also to the embodiment presented in Fig. 2.

Fig. 2 shows a reaction chamber, a tube furnace, with three modules mechanically coupled to each other. The reaction chamber module 110 may basically be similar to that shown in the previous embodiments. In a first side of the reaction chamber module 110 the reactor comprises a pre-processing module 251. It may be a load lock that is mechanically coupled to the reaction chamber module 110 by the gate valve 111 or similar. After at least one batch of substrates has been loaded into the pre-processing module 251 via a hatch or gate 211 or similar, the at least one batch of substrates can be pre-processed in that module 251. For example, the at least one batch of substrates can be pre-heated in the pre-processing module 251 into the processing temperature range by heat transport. In an embodiment, inactive gas, such as nitrogen or similar, is conducted into the pre-processing module 251 from an inactive gas source. The inactive gas in the pre-processing module 251 is heated by at least one heater 260 located in or in the outside of the pre-processing module 251. The at least one batch of substrates in the pre-processing module 251 is heated by the heated inactive gas by heat transport.

After pre-processing, the pre-processing module 251 is pumped into vacuum, the gate valve 111 is opened and the carriage or substrate holder carrying the pre-processed at least one batch of substrates is moved into the reaction chamber module 110 for ALD processing.

In a second (opposite) side of the reaction chamber module 110 the reactor comprises a post-processing module 252. It may be a load lock that is mechanically coupled to the reaction chamber module 110 by the gate valve 112 or similar. After processing, the gate valve 112 is opened and the carriage or substrate holder carrying the ALD processed at least one batch of substrates is moved into the post-processing module 252 for post-processing. For example, the processed at least one batch of substrates can be cooled in the post-processing module 252 by heat transport. In an embodiment, inactive gas, such as nitrogen or similar, is conducted into the post-processing module 252 from an inactive gas source. The pressure of the post-processing module 252 can be raised (into room pressure, for example) and the at least one batch of substrates in the post-processing module 252 is cooled by heat transport from the at least one batch of substrates comprising heat conduction through the inactive gas and natural and/or forced convection of the inactive gas. The walls of the post-processing module can be cooled for example with water-cooled piping. Warmed inactive gas can be conducted into an external heat exchange unit, cooled in the external heat exchange unit and returned by pumping to the post-processing module 252.

After post-processing, the hatch or gate 212 is opened and the carriage or substrate holder carrying the post-processed at least one batch of substrates is moved out of the post-processing module 252.

The embodiment shown in Fig. 2 thus illustrated a modular deposition reactor. In an alternative example, either of the pre- and post-processing modules is omitted. In an alternative embodiment, there is therefore implemented a deposition reactor substantially consisting of a pre-processing module and a reaction chamber module. And, in yet another example, there is implemented a deposition reactor substantially consisting of a reaction chamber module and a post-processing module.

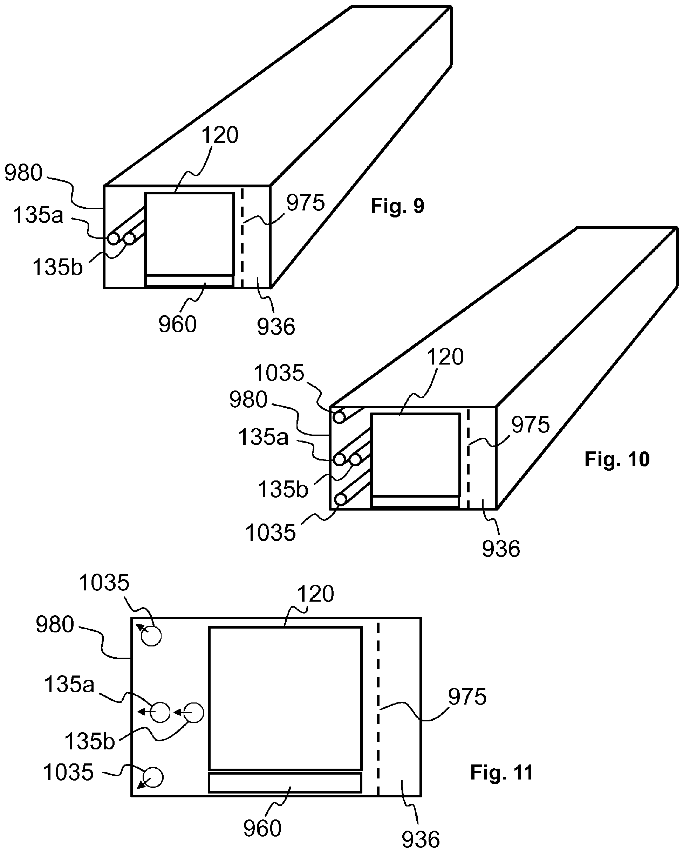

Fig. 3 shows the type of a carriage shown in Figs. 1A-1J for carrying batches of substrates in accordance with another example embodiment. Instead of carrying batches of round wafers, the carriage 115 shown in Fig. 3 is used to carry square shaped wafers. As shown in the enlargement of Fig. 4, the substrates can form horizontal stacks put both horizontally and vertically next to each other. In the example shown in Figs. 3 and 4, each batch of substrates has a 3 x 3 horizontal stack structure in which three horizontal stacks have been placed on top of each other and three such columns horizontally next to each other. The precursor vapor and purge gas flows along the surface of each substrate vertically from top to bottom as shown in Fig. 5A. In embodiments shown for example in Figs. 9-11 the flow is a mainly horizontal flow along the surface of each substrate from left to right or from right to left depending on the viewing angle as shown in Fig. 5B.

Figs. 6-11 show different design alternatives of the deposition reactor and deposition reactor modules in accordance with certain embodiments.

Figs. 6-7 show side views of curved rectangular tube furnaces. In the embodiment shown in Fig. 6 the reaction chamber module 110 comprises horizontally adjacent precursor vapor in-feed lines 135a, 135b, whereas in the embodiment shown in Fig. 7 the horizontal in-feed lines 135a, 135b are vertically adjacent. Because ALD precursors are typically reactive with each other, each precursor vapor flows preferably along its dedicated in-feed line to the reaction chamber to prevent thin film deposition inside the in-feed line. A substrate holder 660 in the carriage 115 carries a batch of square shaped substrates 120 one of which is shown in Figs. 6 and 7. The in-feed lines 135a, 135b have openings on their upper surface via which precursor vapor and purge gas is deflected via the curved ceiling so as to generate a uniform top-to-bottom flow along substrate surfaces. The carriage 115 has the mesh (reference numeral 675) attached to it the function of which has been discussed in the foregoing.

In the embodiment shown in Fig. 8, the reaction chamber module 110 comprises additional inactive gas in-feed lines 835 in the top corners of the module 110 to enhance purging of the reaction chamber. Flow rate of inactive gas along the additional inactive gas in-feed lines 835 can vary during the deposition process. For example, during the precursor pulse time the flow rate is low in inactive in-feed lines 835 to minimize inert gas shielding of the upper corners of the substrates and during the purge time between the precursor pulses the flow rate is high in inactive in-feed lines 835 to enhance purging of the reaction chamber. Nitrogen or argon can be used as the inactive gas in most cases. The in-feed lines 835 may be perforated pipelines having openings on their upper surface so that inactive gas initially flows in the direction(s) shown in Fig. 8.

Figs. 9-10 show side views of rectangular tube furnaces. A substrate holder or carriage 960 which can be horizontally moved within the reaction chamber module 110 carries a batch of square shaped substrates 120 one of which is shown in Figs. 9-10. In the embodiment shown in Fig. 9 the reaction chamber module 110 comprises horizontally adjacent precursor vapor in-feed lines 135a, 135b for producing horizontal precursor vapor flow along substrate surfaces. The in-feed lines 135a, 135b have openings on their side surface via which precursor vapor and purge gas is deflected via a side wall 980 of the module 110. In this way a uniform horizontal (left-to-right) flow along substrate surfaces is generated. The gas flow finally passes via a vertical mesh 975 into an exhaust channel 936.

In the embodiment shown in Fig. 10 the reaction chamber module 110 comprises additional inactive gas in-feed lines 1035 in the corners of the side wall 980 to enhance purging of the reaction chamber. The in-feed lines 1035 may be perforated pipelines having openings on their surfaces so that inactive gas initially flows in the direction(s) shown in Fig. 11, that is, towards the corners.

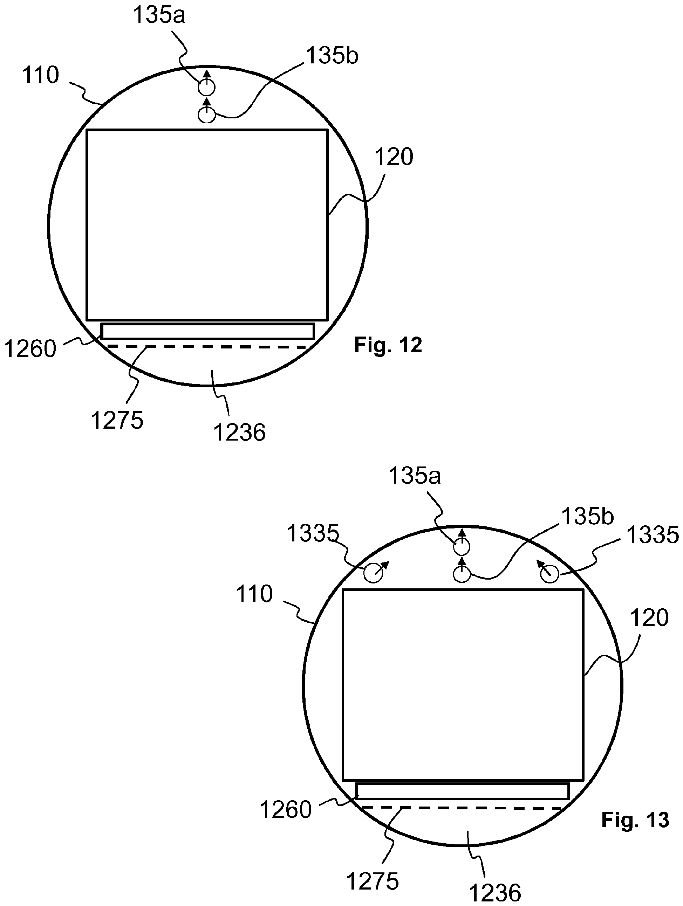

Figs. 12-13 show cross-sectional views of round tube furnaces. A substrate holder or carriage 1260 which can be horizontally moved within the reaction chamber module 110 carries a batch of square shaped substrates 120. In the embodiment shown in Fig. 12 the reaction chamber module 110 comprises vertically adjacent horizontal precursor vapor in-feed lines 135a, 135b. The in-feed lines 135a, 135b have openings on their upper surface via which precursor vapor and purge gas is deflected via the round ceiling so as to generate a uniform top-to-bottom flow along substrate surfaces. The module 110 has the mesh (reference numeral 1275) on the bottom. The volume below the mesh 1275 forms an exhaust channel 1236. In the embodiment shown in Fig. 13, the reaction chamber module 110 comprises additional inactive gas in-feed lines 1335 near the ceiling of the module 110 to enhance purging of the reaction chamber.

Figs. 14A-14D show a method of batch processing in a deposition reactor in accordance with another example embodiment. The method shown in Figs. 14A-14D basically corresponds to the method shown with reference to Figs. 1A-1J in the foregoing. The difference is that instead of processing a plurality of batches at the same time, in the current embodiment only a single batch is processed at the time. However, in the side direction, the batch on the carriage 1415 may be fairly long enabling hundreds or even thousands of substrates to be processed simultaneously. The processing capacity can be increased by setting horizontal stacks of substrates in rows and columns as shown in Fig. 14A (and in Figs. 3 and 4 in the foregoing). Visible are also the at least one heater (reference numeral 1461) heating the reaction space of the reaction chamber module 110 and the thermal insulation layer (reference numeral 1462) covering the at least one heater 1461 in directions other than the one pointing towards the reaction space.

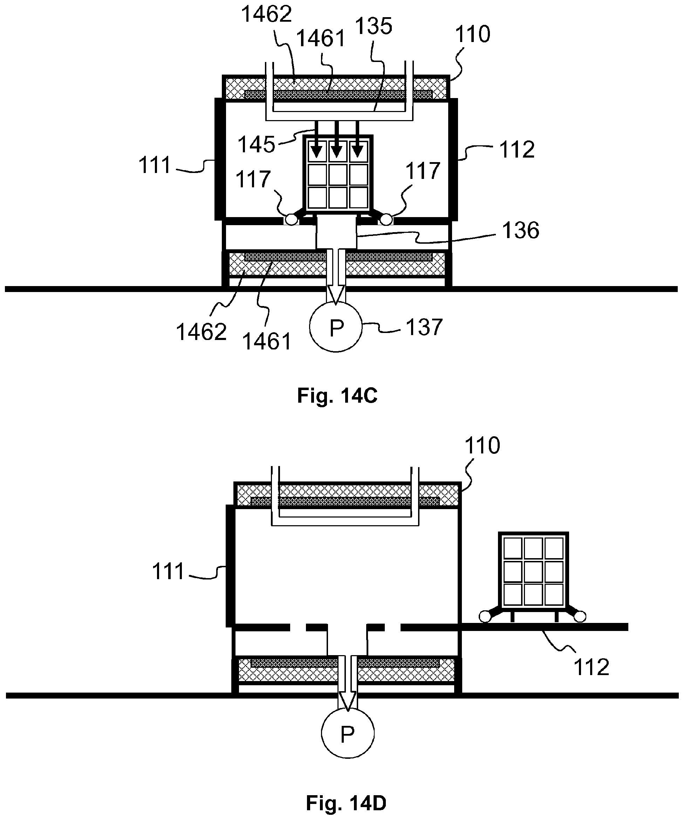

Otherwise the reference numbering and the operations in Figs. 14A-14D corresponds to those used in Figs. 1A-1J. Fig. 14A shows the loading of the carriage 1415 into the reaction chamber module 110 via gate 111. Figs. 14B and 14C shows the lowering of the wheels of the carriage 117 into the recesses 127 and the gaseous flow into the confined box housing the substrates during processing. Figs. 14D shows the unloading of the processed batch of substrates on the carriage 1415 via gate 112.

The foregoing description has provided by way of non-limiting examples of particular implementations and embodiments of the invention a full and informative description of the best mode presently contemplated by the inventors for carrying out the invention.

Furthermore, some of the features of the above-disclosed embodiments of this invention may be used to advantage without the corresponding use of other features. As such, the foregoing description should be considered as merely illustrative of the principles of the present invention, and not in limitation thereof. Hence, the scope of the invention is only restricted by the appended patent claims.

## Claims

1. A method comprising:
providing a reaction chamber module (110) of an atomic layer deposition reactor for processing a batch of substrates (120) carried by a carriage (115) by an atomic layer deposition process;
pre-processing the batch of substrates carried by a carriage in a pre-processing module (251) of the atomic layer deposition reactor;
loading the carriage carrying the batch of substrates before processing into the reaction chamber module via a different route than the batch of substrates is unloaded after processing;
processing the pre-processed batch of substrates by the atomic layer deposition process in the reaction chamber module (110) of the reactor;
wherein said processing by the atomic layer deposition process comprises depositing material on the batch of substrates by sequential self-saturating surface reactions; and
wherein said pre-processing module (251) is a pre-heating module and said pre-processing comprises pre-heating the batch of substrates by heat transport with an inactive gas.

2. The method of claim 1, further comprising post-processing the processed batch of substrates in a post-processing module (252) of the reactor, where the pre-processing module, the reaction chamber module, and the post-processing module are located in a row.

3. The method of claim 2, wherein said post-processing module is a cooling module and said post-processing comprises cooling the batch of substrates.

4. The method of any preceding claim 2 - 3, comprising transporting the batch of substrates in one direction through the whole processing line, the processing line comprising the pre-processing, reaction chamber and post-processing modules.

5. The method of any preceding claim 2 - 4, wherein the pre-processing module is a first load lock, and the method comprises pre-heating the batch of substrates in a pressure above vacuum pressure in the first load lock by means of heat transport and wherein the post-processing module is a second load lock, and the method comprises cooling the batch of substrates in a pressure above vacuum pressure in the second load lock by means of heat transport.

6. The method of any preceding claim, comprising depositing aluminum oxide on a solar cell structure.

7. The method of any preceding claim, comprising processing a batch of vertically oriented substrates carried by the carriage in the reaction chamber module by the atomic layer deposition process.

## Patentansprüche

1. Verfahren, umfassend:
Bereitstellen eines Reaktionskammermoduls (110) eines Atomlagenabscheidungsreaktors zum Verarbeiten einer Charge von Substraten (120), die von einem Schlitten (115) getragen werden, mit einem Atomlagenabscheidungsprozess;
Vorverarbeiten der Charge von Substraten, die von einem Schlitten getragen werden, in einem Vorverarbeitungsmodul (251) des Atomlagenabscheidungsreaktors;
vor dem Verarbeiten Beschicken des Reaktionskammermoduls mit dem Schlitten, der die Charge von Substraten trägt, auf einem anderen Weg, als die Charge von Substraten nach dem Verarbeiten entnommen wird;
Verarbeiten der vorverarbeiteten Charge von Substraten mit dem Atomlagenabscheidungsprozess in dem Reaktionskammermodul (110) des Reaktors;
wobei das Verarbeiten mit dem Atomlagenabscheidungsprozess ein Abscheiden von Material auf der Charge von Substraten durch aufeinanderfolgende Sättigungsreaktionen an der Oberfläche umfasst; und
wobei das Vorverarbeitungsmodul (251) ein Vorheizmodul ist und die Vorverarbeitung ein Vorheizen der Charge von Substraten mittels Wärmetransport mit einem inaktiven Gas umfasst.

2. Verfahren nach Anspruch 1, ferner umfassend:
Nachverarbeiten der verarbeiteten Charge von Substraten in einem Nachverarbeitungsmodul (252) des Reaktors, wo das Nachverarbeitungsmodul, das Reaktionskammermodul und das Nachverarbeitungsmodul in einer Reihe angeordnet sind.

3. Verfahren nach Anspruch 2, wobei das Nachverarbeitungsmodul ein Kühlmodul ist und das Nachverarbeiten ein Abkühlen der Charge von Substraten umfasst.

4. Verfahren nach einem der vorhergehenden Ansprüche 2 bis 3, das ein Transportieren der Charge von Substraten in einer Richtung durch die gesamte Verarbeitungslinie umfasst, wobei die Verarbeitungslinie das Vorverarbeitungs-, das Reaktionskammer- und das Nachverarbeitungsmodul umfasst.

5. Verfahren nach einem der vorhergehenden Ansprüche 2 bis 4, wobei das Vorverarbeitungsmodul eine erste Schleuse ist und das Verfahren ein Vorwärmen der Charge von Substraten bei einem Druck über Vakuum in der ersten Schleuse mittels Wärmetransport umfasst und wobei das Nachverarbeitungsmodul eine zweite Schleuse ist und das Verfahren ein Abkühlen der Charge von Substraten bei einem Druck über Vakuum in der zweiten Schleuse mittels Wärmetransport umfasst.

6. Verfahren nach einem vorhergehenden Anspruch, das ein Abscheiden von Aluminiumoxid auf einer Solarzellstruktur umfasst.

7. Verfahren nach einem vorhergehenden Anspruch, das ein Verarbeiten einer Charge von vertikal ausgerichteten Substraten, die von dem Schlitten getragen werden, in dem Reaktionskammermodul mit dem Atomlagenabscheidungsprozess umfasst.

## Revendications

1. Un procédé comprenant :
le fait de prévoir un module (110) formant chambre de réaction d'un réacteur de dépôt de couche atomique pour traiter un lot de substrats (120) porté par un transporteur (115) par un procédé de dépôt de couche atomique ;
le fait de prétraiter le lot de substrats porté par un transporteur dans un module de prétraitement (251) du réacteur de dépôt de couche atomique ;
le fait de charger le transporteur transportant le lot de substrats avant traitement dans le module formant chambre de réaction par une voie différente de celle du déchargement du lot de substrats après traitement ;
le fait de traiter le lot prétraité de substrats par le procédé de dépôt de couche atomique dans le module (110) formant chambre de réaction du réacteur ;
ledit traitement par le procédé de dépôt de couche atomique comprend le fait de déposer de la matière sur le lot de substrats par des réactions de surface auto-saturantes séquentielles ; et
ledit module de prétraitement (251) étant un module de préchauffage et ledit prétraitement comprenant le fait de préchauffer le lot de substrats par transport de chaleur avec un gaz inactif.

2. Le procédé selon la revendication 1, comprenant en outre le fait de post-traiter le lot traité de substrats dans un module de post-traitement (252) du réacteur, dans lequel le module de prétraitement, le module formant chambre de réaction et le module de post-traitement sont situés selon une rangée.

3. Le procédé selon la revendication 2, dans lequel ledit module de post-traitement est un module de refroidissement et ledit post-traitement comprend le fait de refroidir le lot de substrats.

4. Le procédé selon l'une quelconque des revendications 2 à 3 précédentes, comprenant le fait de transporter le lot de substrats dans un sens à travers toute la ligne de traitement, la ligne de traitement comprenant les modules de prétraitement, de chambre de réaction et de post-traitement.

5. Le procédé selon l'une quelconque des revendications 2 à 4, dans lequel le module de prétraitement est un premier sas de chargement, et le procédé comprend le fait de préchauffer le lot de substrats à une pression supérieure à la pression de vide dans le premier sas de chargement par des moyens de transport de chaleur et dans lequel le module de post-traitement est un deuxième sas de chargement, et le procédé comprend le fait de refroidir le lot de substrats sous une pression supérieure à la pression de vide dans le deuxième sas de chargement au moyen d'un transport de chaleur.

6. Le procédé selon l'une quelconque des revendications précédentes, comprenant le fait de déposer de l'oxyde d'aluminium sur une structure de cellule solaire.

7. Le procédé selon l'une quelconque des revendications précédentes, comprenant le fait de traiter un lot de substrats orientés verticalement porté par le transporteur dans le module formant chambre de réaction par le procédé de dépôt de couche atomique.
